## Europäisches Patentamt

## European Patent Office

## Office européen des brevets

(19)

(11) Veröffentlichungsnummer: **0 082 463**
**B1**

(12) # EUROPÄISCHE PATENTSCHRIFT

(45) Veröffentlichungstag der Patentschrift:
**29.10.86**

(51) Int. Cl.⁴: **G 03 F 7/26**, G 03 F 7/08,
G 03 F 7/10

(21) Anmeldenummer: **82111582.1**

(22) Anmeldetag: **14.12.82**

(54) **Verfahren zur Herstellung von Reliefbildern.**

(30) Priorität: **23.12.81 DE 3151078**

(43) Veröffentlichungstag der Anmeldung:
**29.06.83 Patentblatt 83/26**

(45) Bekanntmachung des Hinweises auf die Patenterteilung:
**29.10.86 Patentblatt 86/44**

(84) Benannte Vertragsstaaten:
**AT BE CH DE FR GB IT LI NL SE**

(56) Entgegenhaltungen:
**EP - A - 0 006 626**
**EP - A - 0 006 627**
**EP - A - 0 024 916**
**EP - A - 0 049 840**
**US - A - 3 915 706**

(73) Patentinhaber: **HOECHST AKTIENGESELLSCHAFT,**
**Postfach 80 03 20, D-6230 Frankfurt am Main 80 (DE)**

(72) Erfinder: **Ruckert, Hans, Dr., Erbsenacker 21,**
**D-6200 Wiesbaden-Naurod (DE)**

## Beschreibung

Die Erfindung betrifft ein Verfahren zur Herstellung von Reliefbildern, bei dem ein lichtempfindliches Material aus einem Schichtträger und einer lichtempfindlichen Schicht, die als wesentliche Bestandteile

a) eine Verbindung mit mindestens einer durch Säure spaltbaren C–O–C-Bindung,
b) eine bei Bestrahlung eine starke Säure bildende Verbindung und
c) ein in Wasser unlösliches, in wässrig-alkalischen Lösungen lösliches Bindemittel

enthält, bildmässig bestrahlt wird und die Nichtbildstellen mit einer Entwicklerflüssigkeit ausgewaschen werden.

Verfahren der genannten Gattung und die dabei verwendeten lichtempfindlichen Materialien sind bekannt. Diese Materialien liefern positive Kopien der Belichtungsvorlage, d.h. die Schicht wird an den belichteten Stellen in einem Entwickler löslich. Derartige positiv arbeitende Materialien sind in den US-PS 3 779 778, 4 101 323, 4 189 323, der US-PS 4 247 611 und den US-PS 4 250 247, US-PS 4 248 957 und 4 311 782 beschrieben. Bei der Belichtung dieser Materialien wird durch Photolyse der Verbindung b Säure gebildet, die die Spaltung von C–O–C-Gruppen der Verbindung a bewirkt, so dass im Ergebnis die belichteten Bereiche der lichtempfindlichen Schichten im Entwickler löslich werden.

Es ist weiterhin bekannt, auf Basis von 1,2-Naphthochinondiaziden beruhende positiv arbeitende Reproduktionsmaterialien durch eine bestimmte Folge von Behandlungsschritten negativ zu verarbeiten. In der US-PS 3 264 104 ist ein derartiges Umkehrverfahren beschrieben, bei dem die lichtempfindliche Schicht, die bevorzugt thermoplastische Polymere enthält, bildmässig belichtet, mit einer alkalischen Lösung oder mit heissem Wasser behandelt wird, ohne Vorlage belichtet und dann wie üblich entwickelt wird, wobei die ursprünglich bildmässig belichteten Stellen stehenbleiben und die übrigen Stellen ausgewaschen werden.

Ein ähnliches Verfahren ist in der US-PS 3 406 065 beschrieben. Auch hier wird eine Schicht gleicher Art bildmässig belichtet, mit wässrigem Alkali behandelt, ohne auszuwaschen, dann mit alkaliresistentem Lack behandelt und durch Auswaschen der nicht bildmässig belichteten Bereiche entwickelt. Die Entwicklung kann entweder mit organischen Lösungsmitteln oder – wenn die Schicht nach der ersten Alkalibehandlung und vor dem Lackieren ohne Vorlage belichtet wurde – mit wässrig-alkalischen Lösungen erfolgen.

Diese Verfahren haben den Nachteil, dass sie eine verhältnismässig grosse Zahl von Behandlungsschritten erfordern, dass die erste Alkalibehandlung stets mit besonderer Sorgfalt erfolgen muss, um möglichst wenig von der in wässrigem Alkali löslichen belichteten Schicht abzulösen, dass sie den Zusatz von in Alkali schwerlöslichen Polymeren erfordern, die die Verwendbarkeit des Materials für andere Zwecke einschränken, oder dass sie zusätzlich eine Lackierung der belichteten Schicht notwendig machen. Grundsätzlich haben alle Materialien auf Basis von 1,2-Naphthochinondiaziden den Nachteil einer verhältnismässig geringen Lichtempfindlichkeit.

Aus der EP-A-0 024 916 ist ein ähnliches Umkehrverfahren bekannt, bei dem ein Material auf Basis von 1,2-Chinondiaziden nach bildmässiger Belichtung erhitzt, dann ohne Vorlage nachbelichtet und mit wässrigem Alkali zum Negativ entwickelt wird. Das Material enthält in der lichtempfindlichen Schicht bestimmte photochrome Verbindungen, die beim Erwärmen mit den Lichtreaktionsprodukten des Chinondiazids reagieren und zu einer Schichthärtung führen sollen. Dieses Material ist an die Anwesenheit von photochromen Substanzen gebunden, deren Lichtreaktion eine bei manchen Anwendungen störende Verfärbung ergibt. Es weist ebenfalls die den 1,2-Chinondiaziden eigene geringe Lichtempfindlichkeit auf.

Aufgabe der Erfindung war es, ein Umkehrverfahren zur Herstellung negativer Kopien mittels eines normalerweise positiv arbeitenden lichtempfindlichen Materials vorzuschlagen, das eine höhere Lichtempfindlichkeit und eine einfachere Durchführung im Vergleich zu bekannten Umkehrverfahren ermöglicht.

Gegenstand der Erfindung ist ein Verfahren der einleitend angegebenen Gattung.

Das erfindungsgemässe Verfahren ist dadurch gekennzeichnet, dass man das lichtempfindliche Material nach der bildmässigen Bestrahlung auf erhöhte Temperatur erwärmt, abkühlt, dann ganzflächig bestrahlt und danach die nicht bildmässig bestrahlten Schichtbereiche durch Auswaschen entwickelt.

Das zur Herstellung des lichtempfindlichen Materials verwendete lichtempfindliche Gemisch kann als Verbindungen mit säurespaltbaren C–O–C-Bindungen unter anderem monomere und polymere Acetale, monomere und polymere Orthocarbonsäureester, Enolether und N-Acyliminocarbonate enthalten. Solche Gemische sind in den eingangs genannten Druckschriften beschrieben. Dabei werden polymere Acetale und Orthocarbonsäureester besonders bevorzugt. Der Mengenanteil an säurespaltbarer Verbindung beträgt im allgemeinen 9 bis 75, vorzugsweise 15–50 Gew.-%, bezogen auf die nichtflüchtigen Bestandteile der lichtempfindlichen Schicht.

Als strahlungsempfindliche Komponenten, die beim Bestrahlen vorzugsweise starke Säuren bilden bzw. abspalten, sind eine grosse Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

An Diazonium-Salzen kommen die in der Diazotypie bekannten Verbindungen mit ausnutzbarer Absorption zwischen 300 und 600 nm in Frage. Bevorzugt werden Verbindungen, die keine basischen Substituenten enthalten.

Die genannten Oniumsalze werden in der Regel in Form ihrer in organischen Lösungsmitteln löslichen Salze eingesetzt, meist als Abscheidungsprodukt mit komplexen Säuren wie Borfluorwasserstoffsäure, Hexafluorphosphor-, Hexafluorantimon- und -arsensäure.

Es können auch Sulfonsäurehalogenide der positiv arbeitenden o-Chinondiazide verwendet werden.

Grundsätzlich sind als halogenhaltige Strahlungsempfindliche und Halogenwasserstoffsäure bildende Verbindungen alle auch als photochemische Radialstarter bekannten organischen Halogenverbindungen, beispielsweise solche mit mehr als einem Halogentom an einem Kohlenstoffatom oder an einem aromatischen Ring, brauchbar. Beispiele sind in den US-PS 3 515 552, 3 536 489 und 3 779 778, der DE-AS 2 610 842 und den DE-OS 2 718 259 und 2 243 621 beschrieben.

Die Menge der Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5%. Besonders für Kopierschichten von Dicken über 10 µm empfiehlt es sich, relativ wenig Säurespender zu verwenden.

Vorzugsweise enthalten die Gemische ferner ein polymeres, bevorzugt wasserunlösliches Bindemittel, das in organischen Lösungsmitteln löslich ist. Da sich als Entwicklerflüssigkeiten für die belichteten Kopierschichten mit Vorteil wässrigalkalische Lösungen einsetzen lassen und diese im allgemeinen gegenüber Entwicklern auf Basis organischer Lösungsmittel vorgezogen werden, werden insbesondere solche Bindemittel bevorzugt, die in wässrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 90, besonders bevorzugt 55– 85 Gew.-%.

Die bei vielen Positiv-Kopiermaterialien bewährten Phenolharze, vor allem Novolake, haben sich auch hier als besonders vorteilhaft erwiesen. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet.

Zusätzlich können noch zahlreiche andere Harze mitverwendet werden, die entweder wasserlöslich oder aber alkaliunlöslich sein können, z.B. Polyvinylacetate, Polyurethane, Polyacrylate, Polyvinylether und Polyvinylpyrrolidone, die selbst durch Comonomere modifiziert sein können, sowie hydrierte oder teilhydrierte Kolophoniumderivate. Der günstigste Anteil an diesen Harzen richtet sich nach den anwendungstechnischen Erfordernissen und dem Einfluss auf die Entwicklungsbedingungen und beträgt im allgemeinen nicht mehr als 50 Gew.-%. Mengenanteile von etwa 2 bis 35 Gew.-%, bezogen auf die Menge der nichtflüchtigen Schichtbestandteile, werden bevorzugt.

In geringen Mengen kann die lichtempfindliche Schicht für spezielle Erfordernisse wie Flexibilität, Haftung, Glanz etc. ausserdem noch Substanzen wie Polyglykole, Celluloseether, z.B. Ethylcellulose, Netzmittel und feinteilige Pigmente enthalten.

Schliesslich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Firm ihrer Carbinolbasen, besonders bewährt.

Bevorzugte Träger für Schichten von mehr als 10 µm Dicke sind Kunststoffolien, die dann als temporäre Träger für Transferschichten dienen. Dafür und für Farbfolien werden Polyesterfolien bevorzugt. Als Schichtträger für Schichtdicke unter ca. 10 µm werden meist Metalle verwendet. Für Offsetdruckplatten können eingesetzt werden mechanische oder elektrochemisch aufgerauhtes und ggf. anodisiertes Aluminium, das zudem noch chemisch, z.B. mit Polyvinylphosphonsäure, Silikaten oder Phosphaten, vorbehandelt sein kann, ausserdem Mehrmetallplatten mit CU/Cr oder Messing/Cr als oberster Schicht. Für Hochdruckplatten können die erfindungsgemässen Schichten auf Zink- oder Magnesium-Platten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Schichten durch ihre gute Haftung und Ätzfestigkeit auf Kupfer- bzw. Nickel-Oberflächen. Ebenso lassen sich die erfindungsgemässen Gemische als Photoresists verwenden.

Die Beschichtung kann direkt oder durch trockene Schichtübertragung vom temporären Träger erfolgen auf Leiterplatten-Materialien, die aus Isolierplatten mit ein- oder beidseitiger Kupfer-Auflage bestehen, auf Glas oder Keramik-Materialien, die ggf. haftvermittelnd vorbehandelt sind, und auf Silizium, Siliziumoxid- und Siliziumnitrid-Scheiben.

Für die Trocknung nach der Beschichtung können die üblichen Geräte und Bedingungen übernommen werden, Temperaturen um 100 °C und kurzfristig bis 120 °C werden ohne Einbusse an Strahlungsempfindlichkeit vertragen.

Zum bildmässigen Belichten können die üblichen Kopiergeräte wie Röhrenlampen, Xenonimpulslampen, metallhalogeniddotierte Quecksilberdampf-Hochdrucklampen und Kohlenbogenlampen verwendet werden. Die Belichtung kann auch mit kohärentem Licht eines Lasers erfolen. Geeignet für die Zwecke vorliegender Erfindung sind leistungsgerechte kurzwellige Laser, beispielsweise Argon-Lager, Krypton-Ionen-Laser, Farbstoff-Laser und Helium-Cadmium-Laser, die zwischen 300 und 600 nm emittieren. Der Laserstrahl wird mittels einer vorgegebenen programmierten Strich- und/oder Raster-Bewegung gesteuert.

Das Bestrahlen mit Elektronenstrahlen ist eine weitere Bebilderungsmöglichkeit. Hierbei können auch Säurespender verwendet werden, die gegenüber Tageslicht wenig oder gar nicht empfindich sind.

Nach dem bildmässigen Bestrahlen bzw. Belichten wird das Material ohne weitere Zwischenbehandlung erwärmt. Das Erwärmen kann durch Bestrahlung, Konvektion, durch Kontakt mit erwärmten Flächen, z.B. Walzen, oder durch Tauchen in ein erwärmtes Bad einer inerten Flüssigkeit, z.B. Wasser, erfolgen. Die Temperatur kann zwischen 80 und 150, vorzugsweise bei 100 bis 130 °C liegen. Derartige Temperaturen werden von den Gemischen vertragen, ohne dass die Eigenschaften der unbelichteten Bereiche wesentlich verändert werden. Die Dauer des Erwärmens kann je nach Art der Wärmeeinwirkung sehr unterschiedlich sein. Bei Übertragung durch ein Wärmemedium liegt sie im allgemeinen zwischen 5 und 30, vorzugsweise zwischen 5 und 20 Minuten. Bei Anwendung von Infrarot-Durchlaufgeräten können für dünne Schichten schon Verweilzeiten von 1 bis 2 Minuten ausreichen.

Nach dem Erwärmen und Abkühlen wird die lichtempfindliche Schicht einer Totalbelichtung unterworfen, um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schliesst sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wässrige Lösungen von alkalischen Substanzen, z.B. Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Waser als Entwickler geeignet. Die Entwicklung kann unmittelbar nach dem Erwärmen und Abkühlen oder auch in zeitlichem Abstand von z.B. mehreren Stunden erfolgen, ohne dass die gehärteten Schichtbereiche angegriffen werden. Daraus ist zu schliessen, dass die Schichthärtung der belichteten Stellen durch Erwärmen irreversibel ist.

Das erfindungsgemässe Verfahren hat den Vorteil, dass es weder zusätzliche Behandlungsschritte mit Flüssigkeiten noch eine besondere Zusammensetzung des lichtempfindlichen Materials erfordert. Mit üblichen Positivmaterialien auf Basis säurespaltbarer Verbindungen können somit nach Wunsch positive oder negative Kopien hergestellt werden. Der einzige zusätzliche Behandlungsschritt, das Erwärmen, kann zumeist mit vorhandenen Trocknungsgeräten bequem durchgeführt werden. Die Nachbelichtung ohne Vorlage wird am einfachsten wieder mit der Kopierlichtquelle durchgeführt.

Das Verfahren ermöglicht es, die bekannt hohe Bildauflösung der Positivmaterialien auch zur Herstellung von Negativkopien zu nutzen. Ein weiterer Vorteil gegenüber den bekannten Umkehrverfahren mittels Positivmaterialien auf Basis von o-Chinondiaziden ist die hohe Lichtempfindlichkeit der bei dem erfindungsgemässen Verfahren verwendeten Materialien. So ist es möglich, auch Negativkopien mit hoher Auflösung und Schichtdicke zu erhalten.

Da die Lichtreaktion der bei dem erfindungsgemässen Verfahren verwendeten lichtempfindlichen Gemische auf einem völlig anderen Mechanismus beruht als die der o-Chinondiazidschichten, war es nicht zu erwarten, dass sich die säurespaltbaren Gemische in ähnlicher Weise zu einem Negativbild verarbeiten lassen. Insbesondere war es nicht zu erwarten, dass diese Gemische unter Anwendung einfacherer Verfahrensschritte zu einem entsprechenden Ergebnis führen könnten.

Das erfindungsgemässe Verfahren kann zur Herstellung von Druckformen für den Hoch-, Tief- und Flachdruck sowie von Photoresistschablonen für die subtraktive und additive Leiterplattenherstellung, für die galvanische Herstellung von Nikkelrotationszylindern oder für die Maskenherstellung in der Mikroelektronik nach der Lift-off-Technik eingesetzt werden. Wenn die Resistschablone auf einer Schaltung verbleiben soll, zeichnet sie sich gegenüber einer gleichen, nach dem Positivverfahren hergestellten Schablone durch bessere dielektrische Werte aus. Auch als Flachdruckform ergeben die negativ verarbeiteten, belichteten und erhitzten Schichten höhere Druckauflagen als die gleichen Schichten nach Verarbeitung durch Positivkopie.

Die folgenden Beispiele beschreiben bevorzugte Ausführungsformen des erfindungsgemässen Verfahrens. Prozentzahlen und Mengenverhältnisse sind, wenn nichts anderes angegeben ist, in Gewichtseinheiten zu verstehen.

Beispiel 1

Auf einseitig durch Drahtbürsten mechanisch aufgerauhtes Aluminium wurde eine Beschichtungslösung aus

7 Gt eines Kresolformaldehyd-Novolaks mit einem Erweichungsbereich von 105–120 °C nach Kapillar-Methode DIN 53 181,

2 Gt 2-Naphth-2-yloxy-5,5-dimethyl-oxazol-4-on,

0,1 Gt 2-(4-Ethoxy-naphth-1-yl)-4,6-bis-trichlormethyl-s-triazin,

0,1 Gr 4-Diethylamino-azobenzol in

90,8 Gt eines Lösungsmittelgemisches aus Ethylenglykolmonoethylether und Butylacetat (4:1)

aufgebracht und getrocknet. Die Dicke der erhaltenen Schicht entsprach einem Schichtgewicht von 2 g/m².

Nach dem Trocknen wurde unter einer positiven Vorlage belichtet, mit einer 3,5%igen Lösung von Trinatriumphosphat, die durch Zugabe von Natriumhydroxid auf ein pH von 12,6 eingestellt war, entwickelt, mit Wasser abgespült und schliesslich durch Überwischen mit 1%iger Phosphorsäure druckfertig gemacht.

Eine andere Probe des gleichen Materials wurde als Negativ-Druckplatte verarbeitet, indem unter einer negativen Vorlage belichtet, anschliessend 10 Minuten auf 100 °C erwärmt und ohne eine Vorlage dieselbe Zeit oder länger nachbelichtet wurde. Beim Entwickeln im gleichen Entwickler innerhalb der gleichen Zeit entstand das Umkehrbild der Vorlage, das zum Drucken ebenfalls mit Druckfarbe behandelt wurde. Die so behandelten Umkehrplatten ergaben im Vergleich zur Positivplatte im Mittel eine um ca. 20% höhere Druckauflage in der Offset-Druckmaschine.

Ähnliche Ergebnisse wurden erhalten, wenn als spaltbare Verbindung anstelle des genannten Oxazolons die gleiche Menge 2-(4-Benzyloxy-phenoxy)-8-methyl-1,3-benzoxazin-4-on vewendet wurde.

Beispiel 2

Zur Herstellung eines Positiv-Trockenresists für Ätz- und Galvano-Bedingungen wurde die folgende Lösung hergestellt:

61,2 Gt Methylethylketon,

20 Gt des in Beispiel 1 angegebenen Novolaks,

10 Gt des Reaktionsprodukts aus 187 Gt Phenol-Formaldehyd-Novolak (Schmelzbereich 110–120 °C nach DIN 53 181) und 6,56 Gt des Additionsprodukts aus 3 Mol Toluoldiisocyanat und 1 Mol Trimethylolpropan,

4,5 Gt des Bis-(5-ethyl-5-methoxymethyl-1,3-dioxolan-2-yl)ethers von 2-Ethyl-2-methoxymethyl-1,3-propandiol,

4,0 Gt 1,3-Bis-(3,4-dihydronaphth-2-yloxy) propan

0,2 Gt 2-[4-(2-Ethoxy-ethoxy)-naphth-1-yl]-4,6-bis-trichlormethyl-s-triazin und

0,05 Gt Kristallviolett-Base.

Damit wurde eine biaxial verstreckte und thermofixierte 25 µm dicke Folie aus Polyethylenterephthalat so beschichtet, getrocknet und mit einer 12 µm dicken Polypropylen-Deckfolie kaschiert, dass eine gleichmässig dicke Resistschicht zwischen den beiden Folien entstand.

In einem handelsüblichen Laminator wurden nach Abziehen der Deckfolien zwei dieser Resistfolien unter Druck und Wärme beidseitig auf eine blanke Messingplatte zur Herstellung von Kontaktfedern für Schalter laminiert. Nach Abkühlen, Abziehen der Trägerfolien und kurzem Nachtrocknen im Trockenschrank bei 80 °C wurde ein beschichtetes Blech mit einem deckungsgleichen Vorlagenpaar in Form einer Tasche beidseitig einmal positiv und einmal negativ belichtet. Die negativ belichtete Platte wurde im Durchlaufofen mit IR-Strahlern ca. 10 Minuten auf 130 °C erhitzt, nach dem Abkühlen beidseitig ohne Vorlage nachbelichtet und nach einiger Zeit gemeinsam mit der positiv belichteten Platte in einem Sprühentwicklungsgerät entwickelt, das mit einer Entwicklerlösung aus

2,67 Gt Natriummetasilikat × 9 Wasser,

1,71 Gt Trinatriumphosphat × 12 Wasser und

0,17 GT Mononatriumphosphat in

95,45 Gt vollentsalztem Wasser

gefüllt war. Beide identisch aussehende Platten wurden nach Abspülen der alkalischen Entwicklerreste mit handelsüblicher Ferrichlorid-Lösung beidseitig so lange geätzt, bis sie zu glatten Flanken durchgeätzt waren.

Die so erhaltenen Schalterteile waren bezüglich Breite und Randqualität der Federstreifen völlig gleich, was die Kopierqualität und Ätzfestigkeit der Umkehrschicht im Vergleich zur direkt positiv verarbeiteten Positivschicht bestätigte.

Beispiel 3

Zur Herstellung mikroelektronischer Schaltelemente hoher Packungsdichte wurden käufliche, wie üblich hergestellte polierte und oberflächlich zu einer 0,2 µ dicken SiO₂-Schicht oxidierte Silicium-Scheiben mit der folgenden Positiv-Photoresistlösung beschichtet.

In 70 Gt eines Lösungsmittelgemisches aus Ethylenglykolethyletheracetat, Butylacetat und Xylol (8:1) wurden

19 Gt des in Beispiel 1 angegebenen Novolaks,

9,5 Gt Triethylenglykol-bis-diphenoxymethylether,

0,2 Gt 2-(4-Ethoxy-naphth-1-yl)-4,6-bis-trichlormethyl-s-triazin und

1,3 Gt Polyethylacrylat niedrigviskos (Plexisol B 574)

gelöst und die Lösung durch ein 0,5 µm Filter filtriert. Beim Schleuderbeschichten mit dieser Lösung bei 9000 U/min wurden Resistschichten von ca. 1,2 µm Dicke erhalten, die noch 10 Minuten bei 90 °C im Umluftschrank getrocknet wurden. Nach dem Abkühlen und Konditionieren auf das definierte Raumklima wurde in einem Wafer-Kontaktbelichtungsgerät unter einer handelsüblichen Chrom-Maske mit hochaufgelösten Testfeldern mit einer 200 Watt Hg-Hochdrucklampe 1 Sekunde belichtet. Entwickelt wurde be 25 °C 1 Minute in einer bewegten Lösung des in Beispiel 2 genannten Entwicklers, der jedoch 1:1 mit voll entsalztem Wasser verdünnt war. Es wurde ein positives Bild der Vorlage erhalten.

Eine weitere Probe des lichtempfindlichen Materials wurde nach dem bildmässigen Belichten unter der entsprechenden umgekehrten Chrommaske 30 Minuten auf 120 °C erwärmt, ohne Vorlage nachbelichtet und dann ebenso wie oben entwickelt. Es wurde eine ähnliche Resistmaske erhalten, die für mikrolithographische Prozesse wie SiO₂-Ätzung oder Dotierungen gleichermassen geeignet ist. Durch das Nacherwärmen vor dem Entwickeln wurde die Ätzresistenz erhöht, ohne dass die entwickelten Resistprofile durch das Tempern verändert wurden (postbake-flow). Ausserdem kann man mittels dieses Umkehrverfahrens die Vorteile der höheren Auflösung und schärferen Resistkanten des Positivresistmaterials im Vergleich zu den üblichen, mit organischen Lösungsmitteln zu verarbeitenden Negativ-Mikroresists nutzen.

Beispiel 4

Eine Aluminium-Platte aus elektrolytisch aufgerauhtem und anodisiertem Aluminium wurde mit einer 2,2 µm dicken Schicht aus

2    Gt Novolak wie in Beispiel 1,

0,4  Gt eines polymeren Orthocarbonsäureesters aus Orthoameisensäuretrimethylester und 1,2,6-Hexantriol,

0,13 Gt des in Beispiel 2 angegebenen s-Triazins,

0,007 Gt Kristallviolett-Base

versehen. Diese Schicht wurde in einem Laserbelichtungsgerät (Laserite® 150 R der Eocom Corp., USA) mit einem Argonionen-Laser mit 6 mJ/cm² bildmässig bestrahlt. Durch Variation der Schreibgeschwindigkeit wurde die Empfindlichkeit von Schichtvarianten ermittelt. Die belichteten Schichtteile wurden innerhalb 2 Minuten mit dem Entwickler aus

5,5 Gt Natriummetasilikat × 9 Wasser,

3,4 Gt Trinatriumphosphat × 12 Wasser,

0,4 Gt Mononatriumphosphat (wasserfrei),

90,7 Gt vollentsalztem Wasser

entfernt.

Durch Einfärben der unbestrahlten Bereiche mit fetter Farbe lässt sich die Laserspur noch deutlicher hervorheben.

Mit einer gleichen Platte wurde eine Umkehrverarbeitung durchgeführt, indem sie nach der Laser-Bestrahlung in einem üblichen Infrarot-Durchlauferhitzungsgerät auf mindestens 90 °C erhitzt, dann ganzflächig unter einer Kopierlampe nachbelichtet und schliesslich in gleicher Weise wie die Positivplatte entwickelt wurde.

Beispiel 5

In diesem Beispiel wird gezeigt, wie mit der folgenden Photoresistlösung galvanoplastisch Nickel-Rotationsschablonen für den Textildruck hergestellt werden können. Eine Lösung aus

40    Gt Methylethylketon,

15    Gt Ethylenglykolethyletheracetat,

5     Gt Diethylenglykolmonoethylether,

28    Gt Novolak wie in Beispiel 1,

3,5 Gt Polyvinylethylether (Lutonal A 25),

8,3 Gt des Polyacetals aus 2-Ethylbutyraldehyd und Triethylenglykol,

0,2 Gt 2-(6-Methoxy-naphth-2-yl)-4,6-bis-trichlormethyl-s-triazin und

0,01 Gt Kristallviolettbase

wurde hergestellt. Auf einen blanken, etwas kontrahierbaren Nickelzylinder, der mit einer leitenden Trennschicht versehen war, wurde durch 2-maliges Sprühbeschichten mit Zwischentrocknung eine 75 µm dicke Schicht guter Oberflächenqualität aufgebracht. Der dabei rotierende Zylinder wurde anschliessend ca. 30 Minuten unter Infrarotstrahlern ausreichend getrocknet.

Unter einem Positiv des zu druckenden Motivs, dessen Tonwertabstufungen mit einem Raster von 32 Linien/cm in Bildpartien unterschiedlicher Flächendeckung umgesetzt waren, wurde ausreichen belichtet. Für eine Positivschicht der halben Dicke auf Basis von o-Naphthochinondiazid war die 6-fache Belichtungszeit nötig. Entwickelt wurde mit einer Lösung von

0,5% NaOH,

0,8% Natriummetasilikat × 9 Wasser,

1,0% Ethylenglykolmono-n-butylether in

97,7% vollentsalztem Wasser.

Dazu wurde der rotierende belichtete Zylinder in eine mit dem Entwickler halbgefüllte Wanne entsprechender Grösse eingetaucht. Die Entwicklerresistenz der Schicht war sehr gut und ermöglichte steile Flanken der Resistkanten. Nach 6 Minuten Rotieren des Zylinders im Entwickler wurde die Entwicklerwanne weggezogen und der Zylinder mit Wasser gespült und an der Luft getrocknet.

Auf den freigelegten Stellen des Zylinderkerns wurde galvanisch Nickel bis zu einer Dicke von 0,1 mm abgeschieden. Nach Kontrahieren des Zylinderkernes, Ablösen der Resistschablone mit Aceton und Abziehen vom Kern wurde eine elastische Rotations-Schablonendruckform erhalten. Durch die Löcher der Rotationsschablone wurde Farbe bildmässig auf Bedruckstoffe übertragen. Der mögliche Tonumfang ist gegenüber Schablonen auf Basis von Diazoschichten und Negativresists erweitert, da durch die relativ dicke Schicht das Zuwachsen hellerer Bildpunkte, d. h. kleinerer Löcher, beim galvanischen Vernickeln sicherer verhindert werden kann.

Die gleiche Resistschicht kann analog als Umkehrschicht verwendet werden, wenn als Vorlage ein Negativfilm verwendet wird. Da entsprechend dick zu verarbeitende Negativresists nicht auf dem Markt existieren und das Umkopieren grossflächiger Silberfilme teuer ist, empfiehlt sich die Negativverarbeitung dieses hochempfindlichen Positiv-Resists. Dazu wurde nach der Rundbelichtung unter dem Negativfilm zusätzlich nochmals 30 Minuten unter den vorhandenen Infrarotstrahlern erwärmt und der Zylinder ohne Vorlage unter der Lichtquelle nachbelichtet. Es wurde schliesslich ein gleicher Nickeldruckzylinder wie bei positiver Arbeitsweise erhalten.

Ähnliche Ergebnisse wurden erhalten, wenn als spaltbare Verbindung das Polyacetal aus n-Heptanal und Tetraethylenglykol verwendet wurde.

Beispiel 6

In diesem Beispiel wird die Kombination des Direktpositiv- und Umkehrnegativ-Verfahrens für die Herstellung von Feinleiterplatten gezeigt. Dazu wurde ähnlich Beispiel 2 eine Positiv-Trockenresistfolie mit einer Resistschicht von 12 µm Dicke und folgender Zusammensetzung hergestellt:

64    Gt Novolak wie in Beispiel 1,

11    Gt Polyvinylmethylether (Lutonal M 40),

15    Gt Polyacetal aus 2-Ethylbutyraldehyd und Hexan-1,6-diol,

9,5 Gt des Polyorthoesters aus Trimethoxymethan und 5-Oxa-7,7-di-hydroxymethylnonan-1-ol,

0,4 Gt 2-Acenaphth-5-yl-4,6-bis-trichlormethyl-s-triazin und

0,1 Gt Kristallviolettbase.

In einem handelsüblichen Laminator wurde diese Resistfolie auf durchkontaktierte kupferkaschierte Isolierstoffplatten unter Druck und Wärme aufgebracht, abkühlen gelassen und die Trägerfolie abgezogen. Ob die Resistschicht dabei die Löcher überdeckt (Tenting) oder einreisst, ist bei diesem vorteilhaften Verfahren ohne Belang, da im ersten Arbeitsschritt die Lochaugen ohnehin freigelegt werden. Dazu wurde eine negative Vorlage verwendet, bei der nur die Lochbereiche transparent waren. Es wurde ein Doppel der negative Leiterbahn-Vorlage verwendet, bei der die Leiterbahnen wegretuschiert, d.h. abgedeckt waren.

Nach der Belichtung der Lochaugen wurden diese Bereiche mit dem gleichen Entwickler wie in Beispiel 4 entwickelt, d.h. ausgewaschen. Vor der galvanischen Verstärkung und Verzinnung bzw. Pb/Sn-Abscheidung im Bereich der Lochaugen wurde nun mit der negativen Leiterbahn-Vorlage belichtet, aber nicht entwickelt.

Der Lochbereich wurde galvanisch verstärkt. Anschliessend wurde die beschichtete Platte 20 Minuten bei 110°C getempert, vollflächig nachbelichtet und jetzt erst entwickelt. Danach wurde in einem ammoniakalischen Ätzbad das freigelegte Kupfer weggeätzt, wobei eine Cu-Feinleiter-Schaltung mit folgenden Vorteilen erhalten wurde: Auflösung bis unter 50 μm Leiterbahnbreite, zwei Kopierschritte mit einer einzigen Beschichtung, Verwendung praktisch nur einer (Negativ)-Vorlage und ohnehin vorhandener Geräte.

Wird der zweite Kopierschritt nicht wie beschrieben im Umkehrverfahren, sondern im Positivverfahren durchgeführt, so fallen zwar Tempern und Nachbelichten weg; es ist jedoch zusätzlich ein Positivfilm der Leiterbahnvorlage nötig. Ein Vorteil beider Verfahrensvarianten ist der, dass die Zweitkopie durch den Galvanoprozess nicht beeinträchtigt wird und vermieden werden kann, dass die Kopie der Leiterbahnen uneben über die galvanisch schon verstärkten Lochbereiche erfolgen müsste.

Beispiel 7
Eine Positiv-Photoresist-Lösung aus

52   Gt Butanon,
34   Gt Novolak wie in Beispiel 1,
9    Gt 1,3-Bis-(5-butyl-5-ethyl-1,3-dioxan-2-yloxy)-2-butyl-2-ethyl-propan,
4,8  Gt Polyethylacrylat wie in Beispiel 3,
0,18 Gt 2-(4-Ethoxy-naphth-1-yl)-4,6-bis-trichlor-methyl-s-triazin und
0,02 Gt Kristallviolettbase

wurde zu einem Trockenschichtgewicht von 3,9 g/m² auf einen Leiterplattenträger aufgebracht. Nach 5 Minuten Trocknen bei 100°C wurden die beschichteten Träger in einem Elektronenstrahl-Belichtungsgerät mit 11 keV bei 5 μA 5 Sekunden bestrahlt, 15 Minuten auf 100°C nacherhitzt, unter UV-Licht ohne Vorlage nachbelichtet und wie in Beispiel 5 in 30 Sekunden entwickelt. Es wurde ein scharfes Resistbild erhalten, das zum Ätzen des Trägermetalls an den freigelegten, nicht bestrahlten Stellen verwendet werden konnte.

Ähnliche Ergebnisse wurden erhalten, wenn als spaltbare Verbindung der Polyorthoester von Beispiel 6 verwendet und 30 Minuten bei 100°C getempert wurde.

Die Negativ-Verarbeitung der Positivschicht ist möglich bei einer eingestrahlten Energie von ungefähr $5.10^{-2}$ Joule/cm² bis $250.10^{-2}$ Joule/cm². Die praktische Elektronenstrahl-Empfindlichkeit kann durch Optimieren von Dauer und Temperatur der Nacherhitzung noch verbessert werden.

Bei positiver Arbeitsweise, d.h. Elektronen-Bestrahlen und anschliessendem Entfernen der bestrahlten Bereiche mit demselben Entwickler innerhalb 30 Sekunden sind dagegen Mindestenergien von $55.10^{-2}$ bzw. $80.10^{-2}$ Joule/cm² nötig.

**Patentansprüche**

1. Verfahren zur Herstellung von Reliefbildern, bei dem ein lichtempfindliches Material aus einem Schichtträger und einer lichtempfindlichen Schicht, die als wesentliche Bestandteile

a) eine Verbindung mit mindestens einer durch Säure spaltbaren C–O–C-Bindung,

b) eine bei Bestrahlung eine starke Säure bildende Verbindung und

c) ein in Wasser unlösliches, in wässrig-alkalischen Lösungen lösliches Bindemittel

enthält, bildmässig bestrahlt wird und die Nichtbildstellen mit einer Entwicklerflüssigkeit ausgewaschen werden, dadurch gekennzeichnet, dass man das Material nach der bildmässigen Bestrahlung auf erhöhte Temperatur erwärmt, abkühlt, dann ganzflächig bestrahlt und danach die nicht bildmässig bestrahlten Schichtbereiche durch Auswaschen entwickelt.

2. Verfahren nach Anspruch 1, dadurch gekennzeichnet, dass man das Material auf eine Temperatur von 80 bis 150°C erwärmt.

3. Verfahren nach Anspruch 1, dadurch gekennzeichnet, dass man das Material 1 bis 30 Minuten erwärmt.

4. Verfahren nach Anspruch 1, dadurch gekennzeichnet, dass man als durch Säure spaltbare Verbindung (a) ein Orthocarbonsäurederivat, ein Acetal, einen Enolether oder ein N-Acyliminocarbonat verwendet.

5. Verfahren nach Anspruch 1, dadurch gekennzeichnet, dass man als Bindemittel (c) einen Novolak verwendet.

6. Verfahren nach Anspruch 1, dadurch gekennzeichnet, dass man ein Material verwendet, dessen lichtempfindliche Schicht zusätzlich mindestens ein Harz mit einem anderen Löslichkeitsverhalten als das Bindemittel (c) enthält.

7. Verfahren nach Anspruch 1, dadurch gekennzeichnet, dass man die Nichtbildstellen mit einer wässrig-alaklischen Entwicklerlösung auswäscht.

8. Verfahren nach Anspruch 1, dadurch gekennzeichnet, dass man ein lichtempfindliches Material gemäss Anspruch 1 bildmässig unter einer Vorlage belichtet, entwickelt und den Schichtträger an den freigelegten Stellen durch Ätzen oder Metallabscheidung modifiziert, die Restschicht vor oder nach der Modifizierung des Schichtträgers unter einer weiteren Vorlage belichtet, erwärmt, abkühlt und ganzflächig bestrahlt und nach der Modifizierung entwickelt.

9. Verfahren nach Anspruch 8, dadurch gekennzeichnet, dass man als Vorlage bei der ersten Bildbelichtung die Vorlage für die zweite Belichtung verwendet und diese partiell abdeckt.

## Claims

1. A process for preparing relief images, in which a light-sensitive material composed of a support and a light-sensitive layer which contains as essential constituents

a) a compound which has at least one C–O–C bond which is cleavable by acid,

b) a compound which forms a strong acid on irradiation and

c) a binder which is insoluble in water and soluble in aqueous-alkaline solutions
is imagewise irradiated and the non-image areas are washed out with a developer liquid, wherein the material is warmed to an elevated temperature after imagewise irradiation, cooled down and then irradiated over its entire area and those areas of the layer which have not been irradiated imagewise are developed by washing out.

2. The process as claimed in claim 1, wherein the material is warmed to a temperature of 80 to 150 °C.

3. The process as claimed in claim 1, wherein the material is warmed for 1 to 30 minutes.

4. The process as claimed in claim 1, wherein an orthocarboxylic acid derivative, an acetal, an enol-ether or an N-acyliminocarbonate is used as the acid-cleavable compound (a).

5. The process as claimed in claim 1, wherein a novolak is used as binder (c).

6. The process as claimed in claim 1, wherein a material is used the light-sensitive layer of which also contains at lea st one resin having solubility properties which differ from those of binder (c).

7. The process as claimed in claim 1, wherein the non-image areas are washed out by means of an aqueous-alkaline developer solution.

8. The process as claimed in claim 1, wherein a light-sensitive material as defined in claim 1 is imagewise exposed under an original and developed, the support is modified at the bared areas by etching or metal deposition, and the residual layer, before or after the modification of the support, is exposed under a further original, warmed, cooled down, irradiated over its entire area and developed after the modification.

9. The process as claimed in claim 8, wherein the original used in the first imagewise exposure is the partially covered original for the second exposure.

## Revendications

1. Procédé pour l'obtention d'images en relief, dans lequel on irradie selon l'image un matériau photosensible constitué d'un support de couche et d'une couche photosensible qui contient en tant que constituants essentiels

a) un composé comportant au moins une liaison C–O–C pouvant être rompue par un acide,

b) un composé formant un acide fort lors d'irradiation, et

c) un liant insoluble dans l'eau, soluble dans des solutions aqueuses alcalines,
et les zones de non image sont éliminées par lavage avec un liquide de développement, caractérisé en ce que l'on chauffe à und température élevée le matériau photosensible après l'irradiation selon l'image, on le refroidit, puis on l'irradie sur toute sa surface, et les zones de la couche non irradiées selon l'image sont ensuite développées par lavage.

2. Procédé selon la revendication 1, caractérisé en ce que l'on chauffe le matériau à une température de 80 à 150 °C.

3. Procédé selon la revendication 1, caractérisé en ce que l'on chauffe le matériau pendant 1 à 30 minutes.

4. Procédé selon la revendication 1, caractérisé en ce que l'on utilise comme composé (a) dissociable par un acide, un dérivé d'acide orthocarboxylique, un acéral, un énol-éther ou un N-acyliminocarbonate.

5. Procédé selon la revendication 1, caractérisé en ce que l'on utilise comme liant (c) une Novolaque.

6. Procédé selon la revendication 1, caractérisé en ce que l'on utilise un matériau dont la couche photosensible contient en outre au moins une résine ayant un comportement de solubilité différent de celui du liant (c).

7. Procédé selon la revendication 1, caractérisé en ce que l'on élimine les zones de non image par lavage avec une solution de développement aqueuse alcaline.

8. Procédé selon la revendication 1, caractérisé en ce que l'on expose selon l'image, sous un original, un matériau photosensible selon la revendication 1, on le développe et on modifie le support de couche dans les zqnes mises à nu par attaque chimique ou dépôt de métal, on expose sous un autre original la couche restante avant ou après la modification du support de couche, on la chauffe, on la refroidit, puis on l'irradie sur toute sa surface et on la développe après la modification.

9. Procédé selon la revendication 8, caractérisé en ce que l'on utilise, en tant qu'original lors de la première exposition selon l'image, l'original pour la deuxième exposition, et celui-ci est partiellement couvert.